# EUROPEAN PATENT SPECIFICATION

(11) **EP 2 298 954 B1**
(45) Date of publication and mention of the grant of the patent: **13.03.2013**
(21) Application number: 09011915.7
(22) Date of filing: 18.09.2009
(51) Int. Cl.: C23C 14/34

(54) **A PVD method for depositing a coating onto a body and coated bodies made thereof**
PVD-Verfahren zum Abscheiden einer Beschichtung auf ein Werkstück und mit dem Verfahren hergestelltes Werkstück
Procédé de revêtement PVD pour obtenir un revêtement sur un article et article ainsi obtenu

(43) Date of publication of application: 23.03.2011
(73) Proprietor: Sandvik Intellectual Property AB, 811 81 Sandviken (SE)
(72) Inventor: Astrand, Maria, 743 91 Storvreta (SE); Ahlgren, Mats, 187 67 Täby (SE); Blomqvist, Helen, 118 67 Stockholm (SE)
(74) Representative: Hägglöf, Henrik

(56) References cited:
- GB-A- 2 410 254
- US-A1- 2007 218 242
- US-A1- 2007 275 179
- US-B2- 6 824 601

## Description

### Field of invention

The present invention relates to a method of making a coated body using a PVD-method. The PVD-method comprises a sequence varying the substrate bias voltage. The present invention also relates to a coated body made according to the method.

### Background

PVD coatings, especially on cutting tools, are well known in the art. The most commonly known PVD techniques are arc evaporation and magnetron sputtering. It is known in the art to vary the substrate bias voltage depending on the coating composition. Different target compositions can require different substrate bias voltages.

Another PVD depositing technique where the substrate bias voltage is varied is the uni- and bipolar pulsed techniques where the substrate bias voltage is varied at a high frequency.

US 2007/0275179 A1 discloses deposition of an aperiodic, multilayered coating having a MX/LX/MX/LX...laminar structure. The coating produced contains at least one electrically isolating layer. The coating is deposited with Bipolar Pulsed Dual Magnetron Sputtering (BPDMS) where the pulse times are in the range of µs.

Variations of the substrate bias voltage in order to improve PVD coatings have also been tested.

US2007/0218242 discloses a PVD-coating having variations in compressive stress within the coating. The compressive stress variation is obtained by varying the substrate bias voltage.

It is an object of the present invention to obtain a coating having an improved wear resistance.

However, there is a constant strive to further improve the properties of PVD coatings to meet the increasing demands on improved wear resistance and increased tool life.

It is an object of the present invention to obtain a coating having an increased tool life.

It has now been found that the objectives above can be met by depositing a PVD coating by applying a sequence varying the substrate bias voltage in a certain pattern.

### Detailed description of the invention

The present invention relates to a method of making a coated body comprising a coating and a substrate where onto said substrate a coating is deposited, using a PVD deposition process. The coating comprises a nitride, carbide, oxide, boride or mixtures thereof, of one or more elements of groups IVb, Vb, VIb, Al, Y and Si. The deposition process comprises at least one sequence of varying the substrate bias voltage, while maintaining the active targets, where the sequence of varying the substrate bias voltage comprises a subsequence Sᵢ;
- depositing at a first substrate bias voltage, Bᵢ, for a deposition time, Tᵢ, of between 10 seconds and 60 minutes, then, during a ramping time, Rᵢ, of between 10 seconds and 40 minutes, while depositing, gradually changing the substrate bias voltage to a second substrate bias voltage Bᵢ₊₁, where |Bᵢ-Bᵢ₊₁| ≥ 10 V,

the subsequence, Sᵢ, is repeated until i=n where i=0, 1, 2, .... n, and where each new subsequence starts the deposition at the same substrate bias voltage used when ending the previous subsequence.

The value n is 2≤n≤1000, preferably 6≤n≤100 and most preferably 10≤n≤20.

The substrate bias voltage Bᵢ₌₁, Bᵢ₌₂ etc. is suitably between -10 and -300 V and preferably between -20 and -200 V.

The difference between the first and second substrate bias voltage in absolute value, |Bᵢ₊₁-Bᵢ| is preferably ≥ 40 V more preferably ≥70 V, but ≤290 V.

The deposition time, Tᵢ, is preferably between 30 seconds and 30 minutes and more preferably between 1 and 15 minutes.

The ramping time, Rᵢ, is preferably between 20 seconds and 20 minutes, more preferably between 30 seconds and 10 minutes.

By gradually changing the substrate bias voltage is herein meant that it can be changed either continuously or incrementally.

During the deposition process according to the present invention the active targets are maintained. By that is herein meant that the deposition is continued using the same targets through out the sequence of varying the substrate bias voltage.

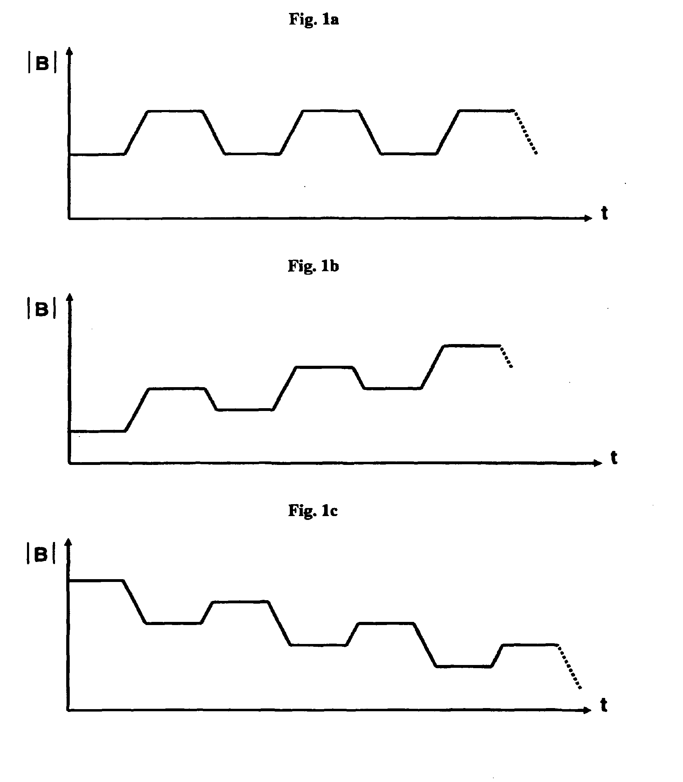

In one embodiment of the present invention, the sequence comprises two different subsequences, A and B, alternated through out the whole sequence of varying the substrate bias voltage. The two subsequences will then be:
A: Depositing at a substrate bias voltage, B₁, for a deposition time, T₁, of between 10 seconds and 60 minutes, then, during a ramping time, R_{1,} of between 10 seconds and 40 minutes, while depositing, gradually changing the substrate bias voltage to a substrate bias voltage, B₂,
B: Depositing at the substrate bias voltage, B₂, for a deposition time, T₂, of between 10 seconds and 60 minutes, then, during a ramping time, R₂, of between 10 seconds and 40 minutes, while depositing, gradually changing the substrate bias voltage to a substrate bias voltage B₁, where |B₁-8₂| ≥ 10 V. The subsequences A and B are alternated. One example of this embodiment is shown in Fig. 1a.

In yet another embodiment of the present invention, the sequence of varying the substrate bias voltage is built up by subsequences such that the substrate bias voltage during deposition at deposition time Tᵢ in the first, third, fifth etc. subsequence is gradually increasing as well as the substrate bias voltage during deposition at deposition time Tᵢ in the second, fourth, sixth etc. subsequence is gradually increasing. One example of this embodiment is shown in Fig. 1b.

In yet another embodiment of the present invention the sequence of varying the substrate bias voltage is built up by subsequences such that the substrate bias voltage during deposition at deposition time Tᵢ in the first, third, fifth etc. subsequence is gradually decreasing as well as the substrate bias voltage during deposition at deposition time Tᵢ in the second, fourth, sixth etc. subsequence is gradually decreasing. One example of this embodiment is shown in Fig. 1c.

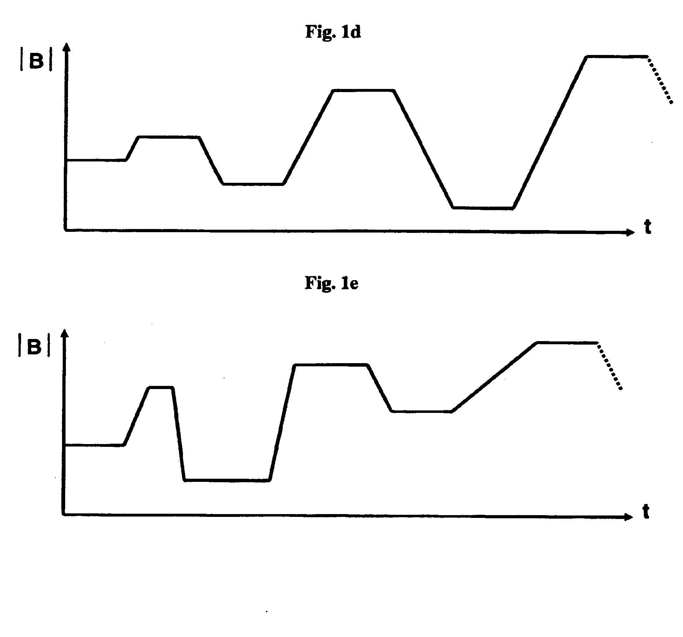

In yet another embodiment of the present invention, the absolute value, |Bᵢ-Bᵢ₊₁l is increasing for each subsequence. One example of this embodiment is shown in Fig. 1d.

In yet another embodiment of the present invention, the sequence is built such that substrate bias voltages, deposition times and ramping times are varied randomly. One example of this embodiment is shown in Fig. 1e.

The method can also comprise a mixture of one or more of the above described embodiments.

The composition of the coating deposited according to the present invention is determined by the target composition and the process gas present in the deposition chamber. The coating deposited according to the present invention, i.e. during the deposited during the at least sequence of varying the substrate bias voltage, is suitably a nitride, carbide, oxide, boride or mixtures thereof of one or more elements of groups IVb, Vb, VIb, Al, Y and Si. Preferably the coating deposited according to the present invention is a nitride of one or more elements of groups IVb, Vb, VIb, Al, Y and Si, more preferably a nitride of one or more of Ti, Al, Cr, Si and Y.

In one embodiment of the present invention, the coating deposited according to the present invention is (Ti,Al)N, preferably with a composition of (Ti₁-xAlₓ)N, where x suitably is between 0.2 and 0.9 preferably between 0.4 and 0.8, most preferably between 0.5 and 0.7.

In another embodiment of the present invention, the coating deposited according to the present invention is (Ti,Al,Cr)N, preferably with a composition (Al_{1-x-y}TiₓCr_{y})N where x is between 0.05 and 0.25, preferably between 0.10 and 0.20, and where y is between 0.05 and 0.30 preferably y is between 0.10 and 0.25 and 0.30<x+y<0.70.

In yet another embodiment of the present invention, the coating deposited according to the present invention is (Ti,Al,Cr,Si)N.

The method according to the present invention can be applied to all common PVD techniques, like cathodic arc evaporation, magnetron sputtering, high power pulsed magnetron sputtering (HPPMS), ion plating etc., preferably cathodic arc evaporation or magnetron sputtering. Process parameters, other than the substrate bias voltage, are conventional in the art for depositing PVD-coatings onto substrates and depend on the specific deposition equipment, coating composition etc. Typically, the deposition temperature varies between 100 and 900°C.

The pressure during deposition is typically between 0.1 to 10 Pa of the process gas present. The process gas can be one or more of O₂, N₂, Ar, C₂H₂, CH₄ or silicon containing gases like e.g. trimethylsilane depending on the aimed coating composition.

Substrates suitable for the present invention are preferably cutting tools, like cutting tool inserts, or round tools such as drills, end mills, taps etc. The substrate is preferably made of any of cemented carbide, cermets, ceramics, cubic boron nitride, polycrystalline diamond or high speed steels, more preferably cemented carbide.

In one embodiment of the present invention, the substrate can be pre-coated with an inner layer deposited directly onto the substrate to ensure a good adhesion to the substrate, the inner layer comprising a pure metal and/or a nitride, preferably Cr, Ti, CrN or TiN, said layer being 0.005-0.5 µm, preferably 0.02-0.2 µm and is deposited within the same coating process as the rest of the coating.

In one embodiment of the present invention, the method can further comprise deposition of other PVD layers without the sequence of varying the substrate bias voltage, i.e. at conventional deposition conditions. These additional deposition sequences can be performed either prior to or after the sequence with varying the substrate bias voltage. These additional deposition sequences take place in the same deposition apparatus as the rest of the deposition steps.

In one embodiment of the present invention, the method can further comprise one or more additional sequences according to the present invention where the active targets are changed between each sequence, i.e. during the sequence of varying the substrate bias voltage the active targets does not change, but the active targets can be changed if a new sequence is started.

The total coating thickness is between 0.5 and 20 µm, preferably between 0.5 and 8 µm and most preferably between 1 and 6 µm.

All thicknesses given herein refer to measurements conducted on a reasonably flat surface being in direct line of sight from the targets. For inserts, being mounted on sticks during deposition, it means that the thickness has been measured on the middle of a side directly facing the target. For irregular surfaces, such as those on e.g. drills and end mills, the thicknesses given herein refers to the thickness measured on any reasonably flat surface or a surface having a relatively large curvature and some distance away from any edge or corner. For instance, on a drill, the measurements have been performed on the periphery and on an end mill the measurements has been performed on the flank side.

In one embodiment of the present invention, the method further comprises a post treatment step. The post treatment step can e.g. be a brushing, blasting, shot peening, etc.

In one embodiment of the present invention, the sequence if varying the substrate bias voltage is as follows:
a) Deposition at a substrate bias voltage of between -120 to -80 V, preferably between - 110 and -90 V for a period of 2 to 10 minutes, preferably between 4 and 8 minutes;
b) During a period of 30 seconds and 4 minutes, preferably between 1 and 3 minutes, increasing the substrate bias voltage to -220 to -180 V, preferably between -210 and -190 V;
c) Deposition at a substrate bias voltage of between -220 to -180 V, preferably between - 210 and -190 V for a period of 2 to 10 minutes, preferably between 4 and 8 minutes;
d) During a period of 30 seconds and 4 minutes, preferably between 1 and 3 minutes, decreasing the substrate bias voltage to -120 to -80 V, preferably between -110 and -90 V;

Where step a) to d) is repeated until the desired coating thickness is reached.

In yet another embodiment of the present invention, the sequence of varying the substrate bias voltage is as follows:
a) Deposition at a substrate bias voltage of between -90 to -60 V, preferably between -80 and -70 V for a period of 2 to 10 minutes, preferably between 4 and 8 minutes;
b) During a period of 30 seconds and 4 minutes, preferably between 1 and 3 minutes, increasing the substrate bias voltage to -170 to -130 V, preferably between -160 and -140 V;
c) Deposition at a substrate bias voltage of between -170 to -130 V, preferably between - 160 and -140 V; for a period of 2 to 10 minutes, preferably between 4 and 8 minutes;
d) During a period of 30 seconds and 4 minutes, preferably between 1 and 3 minutes, decreasing the substrate bias voltage to -90 to -60 V, preferably between -80 and -70 V;

Where step a) to d) is repeated until the desired coating thickness is reached.

The present invention also relates to coated bodies made according to the method described above.

### Example 1

Cemented carbide end mills with the geometry R216.34-10050-BC22P were coated with PVD arc evaporation using Ti_{0.33}Al_{0.67}-targets. The substrates were first subjected to an etching process, prior to deposition of a starting layer of Ti having a thickness of approximately 0.050 µm.

After that, deposition of the (Ti,Al)N coating took place. The coating was deposited at a temperature of 600°C and at a N₂ pressure of 1.0 Pa. The substrate bias voltage was varied according to the following sequence:
a) Deposition at -100V for 6 minutes
b) During a period of 2 minutes, increasing the substrate bias voltage to -200 V
c) Deposition at -200V for 6 minutes
d) During a period of 2 minutes, decreasing the substrate bias voltage to -100 V Step a) to d) was repeated until the coating reached a coating thickness on the flank side of 2.8 µm.

The end mills are herein referred to as Invention 1.

### Example 2

Cemented carbide end mills of the same geometry and composition as in Example 1 were coated with PVD arc evaporation using Ti_{0.33}Al_{0.67}-targets. The substrates were first subjected to an etching process, prior to depositing a starting layer of Ti having a thickness of approximately 0.050 µm. After that, deposition of the (Ti,Al)N coating took place. The coating was deposited at a temperature of 600°C, at a N₂ pressure of 1.0 Pa, and at a constant substrate bias voltage of 100 V until a final coating thickness of 3.8 µm was reached. The end mills according to Example 2 are herein referred to as Reference 1.

### Example 3

End mills according to Examples 1 and 2 respectively, were tested in a semi-finishing cutting operation in steel at the following cutting conditions:

| | |
|---|---|
| Material: | SS2244 |
| Quantification: | milled length |
| V_{c}= | 300 m/min |
| aₚ= | 10 mm |
| aₑ= | 1 mm |
| f_{z}= | 0.1 mm/tooth |
| Note: | Coolant |
| Tool life criterion: | Vb/Vbmax≥0.15/0.20 |

A third variant, Comparative 1, of the same cemented carbide end mill as in Examples 1 and 2 (composition and geometry), which had been deposited by an external supplier with a homogenous Al₆₅Ti₃₅N layer as analyzed with EDS and with a thickness of 3.2 µm on the flank side was also included as reference. Three end mills of each variant were tested and the results in Table 1 give the average of the three:

**Table 1**

| | Tool life (m) |
|---|---|
| Invention 1 | 323 |
| Reference 1 | 217 |
| Comparative 1 | 220 |

Table 1 clearly shows that the end mills coated according to the present invention, Invention 1, have a considerably longer tool life than prior art, i.e. Reference 1 and Comparative 1.

### Example 4

End mills according to Examples 1 and 2 were tested in a semi-finishing cutting operation in stainless steel at the following cutting conditions:

| | |
|---|---|
| Material: | 316Ti |
| Quantification: | maximum wear in mm at 200 meters milled length |
| V_{c}= | 105 m/min |
| aₚ= | 10 mm |
| aₑ= | 1 mm |
| f_{z}= | 0.071 mm/tooth |
| Note: | Coolant |

A third variant, Comp. 1, of the same cemented carbide end mill as in Examples 1 and 2 (composition and geometry), which had been deposited by an external supplier with a homogenous A1₆₅Ti₃₅N layer as analyzed with EDS and with a thickness of 3.2 µm on the flank side was also included as reference. Two end mills of each variant were tested and the results in Table 2 give the average of the two:

**Table 2**

| | Max wear (mm) |
|---|---|
| Invention 1 | 0.10 |
| Reference 1 | 0.16 |
| Comparative 1 | 0.17 |

Table 2 clearly shows that the end mills coated according to the present invention, Invention 1, have a considerably better wear resistance, i.e. a lower maximum wear, than both Reference 1 and Comparative 1.

### Example 5

Threading inserts of the geometry, 266RG-16MM01A150M, were coated according to the method described in Example 1 to a coating thickness of 2.3 µm and according to the method in Example 2 to a coating thickness of 2.1 µm, respectively. They are herein referred to as Invention 2 and Reference 2. They were tested in an intermittent threading application as follows:

| | |
|---|---|
| Material: | SS2541 |
| Quantification: | Number of threads |
| V_{c}= | 110 m/min |
| number of passes= | 8 |
| Length of thread= | 25 mm |
| Tool life criterion: Vb/Vbₘₐₓ≥0.15 mm | |

Two inserts of each variant were tested and the results in Table 3 give the average of the two:

**Table 3**

| | Tool life (number of threads) |
|---|---|
| Invention 2 | 115 |
| Reference 2 | 65 |

Table 3 clearly shows that the threading inserts coated according to the present invention, Invention 2, have a longer tool life than prior art inserts, i.e. Reference 2.

### Example 6

Cemented carbide threading inserts with the geometry R166.OG-16VM01-002 were coated using PVD arc evaporation with Ti_{0.30}Al_{0.70}-targets and Cr₃ₒAh₇₀-targets. The substrates were first subjected to an etching process, prior to depositing a starting layer of TiN having a thickness of approximately 0.10 µm.

After that, deposition of the (Ti,Cr,Al)N coating took place. The coating is deposited at temperature of 600°C and at a N₂ pressure of 1.0 Pa. The 3-fold rotation of the substrates resulted in alternating layers of TiAIN and AlCrN with sublayer thicknesses in the range 0.2 nm to 30 nm. The substrate bias voltage was varied according to the following sequence:
a) Deposition at -75 V for 6 minutes
b) During a period of 2 minutes, increasing the substrate bias voltage to -150 V
c) Deposition at -150 V for 6 minutes
d) During a period of 2 minutes, decreasing the substrate bias voltage to -75 V Step a) to d) was repeated until the coating reached a coating thickness on the flank face of 2.2 µm. The deposition cycle was ended with a thin TiN color layer of approximately 0.2 µm. The threading inserts are herein referred to as Invention 3.

### Example 7

Cemented carbide threading inserts with the geometry R166.OG-16VM01-002 were deposited with TiN at 450 °C using an ion plating method. The threading inserts are herein referred to as Reference 3.

### Example 8

Threading inserts of Examples 6 and 7, and threading inserts with the same geometry but deposited according to Example 1, referred to herein as Invention 4, were tested in a threading operation as follows:

| | |
|---|---|
| Material: | 316Ti |
| Quantification: | Number of threads |
| V_{c}= | 90 m/min |
| Number of passes= | 14 |
| Length of thread= | 30 mm |
| Tool life criterion: Vb/Vbₘₐₓ≥0.15 mm | |

Two end mills of each variant were tested and the results in Table 4 give the average of the two:

**Table 4**

| | Coating thickness (µm) | Tool life (number of threads) |
|---|---|---|
| Invention 3 | 2.2 | 96 |
| Invention 4 | 2.3 | 96 |
| Reference 3 | 2.8 | 45 |

Table 4 clearly shows that the threading inserts coated according to the present invention, Invention 1 and Invention 2, have a considerably longer tool life than prior art, i.e. Reference 3.

## Claims

1. A method of making a coated body comprising providing a substrate, onto said substrate deposit, using a PVD deposition process, a coating comprising a nitride, carbide, oxide, boride or mixtures thereof, of one or more elements of groups IVb, Vb, VIb, Al, Y and Si **characterized in that** the deposition process comprises at least one sequence of varying the substrate bias voltage, while maintaining the active targets, where the sequence of varying the substrate bias voltage comprises a subsequence Sᵢ;
- depositing at a first substrate bias voltage, Bᵢ, for a deposition time, Tᵢ, of between 10 seconds and 60 minutes, then, during a ramping time, Rᵢ, of between 10 seconds and 40 minutes, while depositing, gradually changing the substrate bias voltage to a second substrate bias voltage Bᵢ₊₁, where |Bᵢ-Bᵢ₊₁| ≥ 10 V,
the subsequence, Sᵢ, is repeated until i=n where i=0, 1, 2, .... n, where 2≤n≤1000 and where each subsequence starts the deposition at the same substrate bias voltage used when ending the previous subsequence.

2. A method according to claim 1 **characterized in that** |Bᵢ₊₁-Bᵢ|, is ≥ 40 V.

3. A method according to any of the proceeding claims **characterized in that** |Bᵢ₊₁-Bᵢ|, is ≥70 V.

4. A method according to any of the proceeding claims **characterized in that** the substrate bias voltage Bᵢ is between -10 and-300 V.

5. A method according to any of the proceeding claims **characterized in that** deposition time, Tᵢ, is between 30 seconds and 30 minutes.

6. A method according to any of the proceeding claims **characterized in that** the ramping time, Rᵢ, is between 20 seconds and 20 minutes.

7. A method according to any of the proceeding claims **characterized in that** the coating deposited during the at least one sequence of varying the substrate bias voltage is a nitride of one or more elements of groups IVb, Vb, VIb, Al, Y and Si.

8. A method according to any of the proceeding claims **characterized in that** the coating deposited during the at least one sequence of varying the substrate bias voltage is (Ti,Al)N.

9. A method according to any of the proceeding claims **characterized in that** the coating deposited during the at least sequence of varying the substrate bias voltage is (Ti,Al,Cr)N.

10. A method according to any of the proceeding claims **characterized in that** the coating is further subjected to a post treatment step.

11. A method according to any of the proceeding claims **characterized in that** the body is a cutting tool.

12. A coated body made according to the method in claims 1-11

13. A coated body according to claim 12 **characterized in that** the body is a cutting tool.

## Patentansprüche

1. Verfahren zum Herstellen eines beschichteten Körpers, bei dem man ein Substrat bereitstellt und auf dem Substrat unter Anwendung eines PVD-Abscheidungsverfahrens eine Beschichtung abscheidet, die ein Nitrid, ein Carbid, ein Oxid, ein Borid oder Gemische davon von einem oder mehreren Element/en der Gruppen IVb, Vb, Vlb, Al, Y und Si aufweist, **dadurch gekennzeichnet, dass** das Abscheidungsverfahren wenigstens eine Sequenz umfasst, bei der die Substratvorspannung variiert wird, während die aktiven Targets beibehalten werden, wobei die Sequenz, bei der die Substratvorspannung variiert wird, eine Untersequenz Sᵢ umfasst;
- Abscheiden bei einer ersten Substratvorspannung Bᵢ über einen Abscheidungszeitraum Tᵢ von zwischen 10 Sekunden und 60 Minuten, dann während einer Rampenphase Rᵢ von zwischen 10 Sekunden und 40 Minuten während des Abscheidens stufenweises Verändern der Substratvorspannung bis zu einer zweiten Substratvorspannung Bᵢ₊₁, wobei |B-Bᵢ₊₁|≥10 V,
wobei die Untersequenz Sᵢ wiederholt wird bis i=n, wobei i=0, 1, 2, ... n, wobei 2≤n≤1000, und wobei jede Untersequenz die Abscheidung bei der gleichen Substratvorspannung beginnt, die angewendet wird, wenn die vorherige Untersequenz beendet wird.

2. Verfahren nach Anspruch 1, **dadurch gekennzeichnet, dass** |Bᵢ₊₁-B₁|≥40 V.

3. Verfahren nach einem der vorangehenden Ansprüche, **dadurch gekennzeichnet, dass** |Bᵢ₊₁-Bᵢ|≥70 V.

4. Verfahren nach einem der vorangehenden Ansprüche, **dadurch gekennzeichnet, dass** die Substratvorspannung Bᵢ zwischen -10 und -300 V beträgt.

5. Verfahren nach einem der vorangehenden Ansprüche, **dadurch gekennzeichnet, dass** die Abscheidungszeit Tᵢ zwischen 30 Sekunden und 30 Minuten beträgt.

6. Verfahren nach einem der vorangehenden Ansprüche, **dadurch gekennzeichnet, dass** die Rampenphase Rᵢ zwischen 20 Sekunden und 20 Minuten beträgt.

7. Verfahren nach einem der vorangehenden Ansprüche, **dadurch gekennzeichnet, dass** die Beschichtung, die während der wenigstens einen Sequenz abgeschieden wird, bei der die Substratvorspannung variiert wird, ein Nitrid von einem oder mehreren Element/en der Gruppen IVb, Vb, Vlb, Al, Y und Si ist.

8. Verfahren nach einem der vorangehenden Ansprüche, **dadurch gekennzeichnet, dass** die Beschichtung, die während der wenigstens einen Sequenz abgeschieden wird, bei der die Substratvorspannung variiert wird, (Ti,Al)N ist.

9. Verfahren nach einem der vorangehenden Ansprüche, **dadurch gekennzeichnet, dass** die Beschichtung, die während der wenigstens einen Sequenz abgeschieden wird, bei der die Substratvorspannung variiert wird (Ti,Al,Cr)N ist.

10. Verfahren nach einem der vorangehenden Ansprüche, **dadurch gekennzeichnet, dass** die Beschichtung außerdem noch einer Nachbehandlungsstufe unterworfen wird.

11. Verfahren nach einem der vorangehenden Ansprüche, **dadurch gekennzeichnet, dass** der Körper ein Schneidwerkzeug ist.

12. Beschichteter Körper, hergestellt nach dem Verfahren der Ansprüche 1 bis 11.

13. Beschichteter Körper nach Anspruch 12, **dadurch gekennzeichnet, dass** der Körper ein Schneidwerkzeug ist.

## Revendications

1. Un procédé de fabrication d'un objet muni d'un revêtement comprenant l'utilisation d'un substrat, sur lequel substrat est déposé, en utilisant un procédé de dépôt physique en phase vapeur (PVD), un revêtement comprenant un nitrure, carbure, oxyde, borure ou des mélanges de ceux-ci, de un ou plusieurs éléments des groupes IVb, Vb, VIb, Al, Y et Si, ce procédé étant **caractérisé en ce que** le procédé de dépôt comprend au moins une séquence de variation de la tension de polarisation du substrat, tout en maintenant actives les cibles, où la séquence de variation de la tension de polarisation du substrat comprend une sous-séquence Sᵢ;
- dépôt sous une première tension de polarisation Bᵢ du substrat, pour une durée de dépôt Tᵢ, comprise entre 10 secondes et 60 minutes, puis, pendant une durée de montée en puissance, Rᵢ, comprise entre 10 secondes et 40 minutes, tout en procédant durant le dépôt, à un changement progressif de la tension de polarisation du substrat jusqu'à une deuxième tension de polarisation du substrat Bᵢ₊₁, où |B₁ - Bᵢ₊₁| est ≥ 10 V,
- la sous-séquence, Si, est répétée jusqu'à ce que i = n, pour i = 0, 1, 2, .... n, et où 2 ≤ n ≤ 1000 et où chaque sous-séquence provoque le dépôt à la même tension de polarisation du substrat que celle utilisée quand se termine la séquence précédente.

2. Un procédé selon la revendication 1, **caractérisé en ce que** |B₁₊₁ - Bᵢ| est
≥ 40 V

3. Un procédé selon l'une quelconque des revendications précédentes, **caractérisé en ce que** |B₁₊₁ - Bᵢ| est ≥ 70 V.

4. Un procédé selon l'une quelconque des revendications précédentes, **caractérisé en ce que** la tension de polarisation du substrat Bᵢ est comprise entre -10 et -300 V.

5. Un procédé selon l'une quelconque des revendications précédentes, **caractérisé en ce que** la durée de dépôt, Tᵢ, est comprise entre 30 secondes et 30 minutes.

6. Un procédé selon l'une quelconque des revendications précédentes, **caractérisé en ce que** le temps de montée en puissance, Rᵢ, est compris entre 20 secondes et 20 minutes.

7. Un procédé selon l'une quelconque des revendications précédentes, **caractérisé en ce que** le revêtement déposé durant la au moins une séquence de variation de la tension de polarisation du substrat est un nitrure de un ou plusieurs éléments des groupes IVb, Vb, VIb, Al, Y et Si.

8. Un procédé selon l'une quelconque des revendications précédentes, **caractérisé en ce que** le revêtement déposé durant la au moins dite séquence de variation de la tension de polarisation du substrat est (Ti,Al) N.

9. Un procédé selon l'une quelconque des revendications précédentes, **caractérisé en ce que** le revêtement déposé au cours de la au moins dite séquence de variation de la tension de polarisation de substrat est (Ti,Al,Cr) N.

10. Un procédé selon l'une quelconque des revendications précédentes, **caractérisé en ce que** le revêtement est en outre soumis à une étape de post-traitement.

11. Un procédé selon l'une quelconque des revendications précédentes, **caractérisé en ce que** l'objet est un outil de coupe.

12. Un objet revêtu fabriqué selon le procédé des revendications 1-11.

13. Un objet revêtu selon la revendication 12, **caractérisé en ce que** l'objet est un outil de coupe.
